(19) Europäisches Patentamt
European Patent Office
Office européen des brevets

(11) **EP 4 498 560 A1**

(12) **EUROPEAN PATENT APPLICATION**
published in accordance with Art. 153(4) EPC

(43) Date of publication:
**29.01.2025 Bulletin 2025/05**

(21) Application number: **22927619.1**

(22) Date of filing: **22.03.2022**

(51) International Patent Classification (IPC):
*H02J 7/00* (2006.01)   *G01R 31/367* (2019.01)
*G01R 31/382* (2019.01)   *H01M 10/48* (2006.01)

(52) Cooperative Patent Classification (CPC):
**G01R 31/367; G01R 31/392; H01M 10/48;
H02J 7/00**

(86) International application number:
**PCT/JP2022/013058**

(87) International publication number:
**WO 2023/181101 (28.09.2023 Gazette 2023/39)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **KABUSHIKI KAISHA TOSHIBA**
**Minato-ku**
**Tokyo 105-0023 (JP)**

(72) Inventors:
• **MARUCHI, Kohei**
  **Tokyo 105-0023 (JP)**
• **YAMAMOTO, Takahiro**
  **Tokyo 105-0023 (JP)**
• **HATANO, Hisaaki**
  **Tokyo 105-0023 (JP)**

(74) Representative: **Hoffmann Eitle**
**Patent- und Rechtsanwälte PartmbB**
**Arabellastraße 30**
**81925 München (DE)**

(54) **INFORMATION PROCESSING DEVICE, INFORMATION PROCESSING METHOD,
INFORMATION PROCESSING SYSTEM, AND COMPUTER PROGRAM**

(57)     [Problem to be solved] There is provided an information processing apparatus, an information processing method, an information processing system, and a computer program for estimating a state of a storage battery.

[Solution] According to one embodiment, an information processing apparatus includes: a feature calculator configured to calculate first feature data based on measured data of a target rechargeable battery in a first range; and an estimator configured to estimate a state of the target rechargeable battery in a third range that differs from the first range based on the first feature data and correspondence information. The correspondence information associates at least one piece of second feature data based on measured data of a rechargeable battery in a second range that is longer than the first range with state-related data that is related to a state of the rechargeable battery.

FIG. 1

EP 4 498 560 A1

## Description

[Technical Field]

The present embodiment relates to an information processing apparatus, an information processing method, an information processing system, and a computer program.

[Background Art]

Use of secondary batteries (storage batteries) is increasing in order to stabilize power systems toward decarbonization, reduce exhaust gas, and the like. Since deterioration of a rechargeable battery gradually progresses according to frequency of use or duration of use even when the rechargeable battery operates normally, a degree of progress of deterioration (degree of soundness) must be evaluated in order to safely operate the rechargeable battery. Furthermore, estimating progress of deterioration in advance enables preparation of a replacement rechargeable battery to be performed at an appropriate time and safe operation of the rechargeable battery to be realized while suppressing maintenance cost.

Methods of estimating the degree of soundness of a rechargeable battery include a method of using an estimation formula (square-root rule) based on an electrochemical simulation and physical properties. With this method, it is difficult to select an appropriate parameter in consideration of an operating state of the rechargeable battery.

On the other hand, lower prices and larger capacities of semiconductors, advances in wireless technology, and the like enable a large amount of case examples of measured data of storage batteries to be accumulated. A method of estimating a transition of a degree of soundness using case examples of measured data is also proposed. However, with this method, although a type of a vehicle or a type of a battery is taken into consideration, a method of operation of the rechargeable battery (a use mode of the rechargeable battery) is not particularly considered. Therefore, it is difficult to estimate a degree of soundness with respect to a rechargeable battery of a different use mode.

[Citation List]

[Patent Literature]

[Patent Literature 1] International Publication No. 2020/044713

[Summary of Invention]

[Technical Problem]

The present embodiment relates to an information processing apparatus, an information processing method, an information processing system, and a computer program for estimating a state of a storage battery.

[Solution to Problem]

According to one embodiment, an information processing apparatus includes: a feature calculator configured to calculate first feature data based on measured data of a target rechargeable battery in a first range; and an estimator configured to estimate a state of the target rechargeable battery in a third range that differs from the first range based on the first feature data and correspondence information. The correspondence information associates at least one piece of second feature data based on measured data of a rechargeable battery in a second range that is longer than the first range with state-related data that is related to a state of the rechargeable battery.

[Brief Description of Drawings]

FIG. 1 is a block diagram of an example of a rechargeable battery evaluation apparatus that is an information processing apparatus according to the present embodiment;
FIG. 2 is a diagram showing a configuration example of a battery energy storage system as an example of a rechargeable battery;
FIG. 3 is a diagram showing a configuration example of a single module;
FIG. 4 is a diagram showing an example of an operation DB;
FIG. 5 is a diagram showing an example of an operation feature case example DB;
FIG. 6 is a diagram showing an example of an operation feature DB;
FIG. 7 is a diagram showing an example of a SoH transition case example DB;
FIG. 8 is a diagram showing an example of estimated transition data of a SoH estimated by a SoH transition estimator;
FIG. 9 is a diagram showing an example of displaying, in addition to estimated transition data of a SoH, data of a SoH transition case example corresponding to a similar case example;
FIG. 10 is a diagram showing an example of displaying, in addition to estimated transition data of a SoH, data of a SoH transition case example of an upper limit and data of a SoH transition case example of a lower limit;
FIG. 11 is a flow chart showing an example of an operation in a learning mode in the rechargeable battery evaluation apparatus according to the present embodiment;
FIG. 12 is a flow chart showing an example of an operation in an estimation mode in the rechargeable battery evaluation apparatus according to the present embodiment;

FIGS. 13A and 13B show an example of a power distribution in a case of a power adjustment application and an example of a power distribution in a case of a power supply application;

FIG. 14 is a block diagram of an example of a rechargeable battery evaluation apparatus that is an information processing apparatus according to a fifth modification of the present embodiment;

FIG. 15 is a diagram showing an example of graphically displaying target SoH transition data and each SoH transition case example; and

FIG. 16 is a diagram showing a hardware configuration example of the rechargeable battery evaluation apparatus according to an embodiment of the present invention.

[Description of Embodiments]

Hereinafter, an embodiment of the present invention will be described with reference to the drawings.

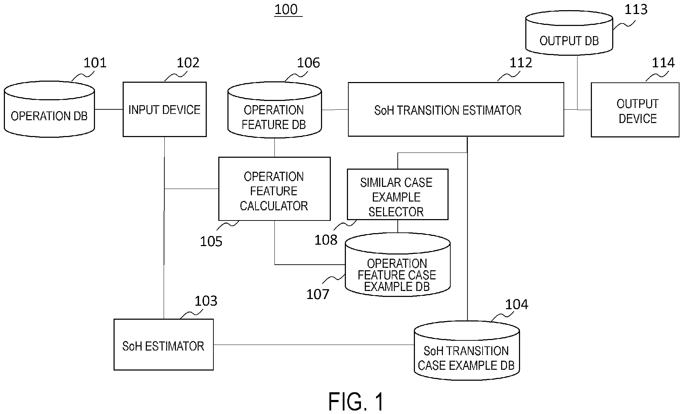

FIG. 1 is a block diagram of an example of a rechargeable battery evaluation apparatus 100 that is an information processing apparatus according to the present embodiment. The rechargeable battery evaluation apparatus 100 includes a database (DB) of case examples (SoH transition case example) of a transition of a degree of soundness (SoH: State of Health) of a plurality of storage batteries having been operated in various use modes (operation types) and a DB of case examples (operation feature case examples) of operation feature data including at least one piece of feature information of the plurality of storage batteries. Based on both DBs and operation feature data (first feature data) of a rechargeable battery that is an evaluation target, a SoH of the rechargeable battery that is an evaluation target or, more specifically, a transition of the SoH is estimated. Accordingly, regardless of the use mode (operation type) of the rechargeable battery that is an evaluation target, a transition of the SoH of the rechargeable battery can be estimated with high accuracy. The SoH of a rechargeable battery is an indicator of a deterioration state representing a degree of progression of deterioration of the rechargeable battery.

Hereinafter, before describing the rechargeable battery evaluation apparatus 100, a rechargeable battery according to the present embodiment will be described. The rechargeable battery is a chargeable/dischargeable battery. While the rechargeable battery is also called a secondary battery in contrast to a primary battery which is only dischargeable, hereinafter, names will be unified to "rechargeable battery". In the present embodiment, charge/discharge is to include at least one of charge and discharge.

For example, the rechargeable battery is a battery mounted to mobile objects that operate using electric energy as a power source such as an electric vehicle (EV), an electric bus, a train, a next-generation light rail transit (LRT) system, a bus rapid transit (BRT) system, an automated guided vehicle (AVG), an airplane, and an ocean vessel. Alternatively, the rechargeable battery may be a rechargeable battery mounted to electrical appliances (a smartphone, a personal computer, and the like), a rechargeable battery for storing power for demand response, or the like. Alternatively, the rechargeable battery may be a rechargeable battery for other applications.

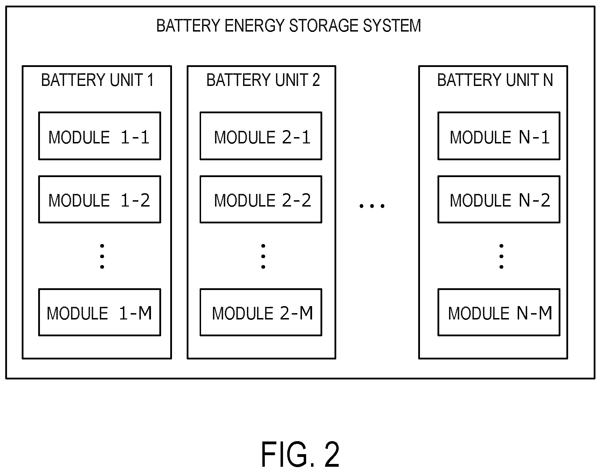

FIG. 2 shows a configuration example of a battery energy storage system 201 as a mode of a rechargeable battery. The battery energy storage system 201 includes battery units 1, 2, ..., N. A plurality of battery units are connected in series, in parallel, or in series and in parallel so that a desired output is obtained according to application. In addition, each battery unit includes a plurality of modules. The battery unit 1 includes modules 1-1 to 1-M, the battery unit 2 includes modules 2-1 to 2-M, and the battery unit N includes modules N-1 to N-M. The plurality of modules are connected in series, in parallel, or in series and in parallel. While the number of modules included in each battery unit is the same in the present example, the number of modules need not be the same.

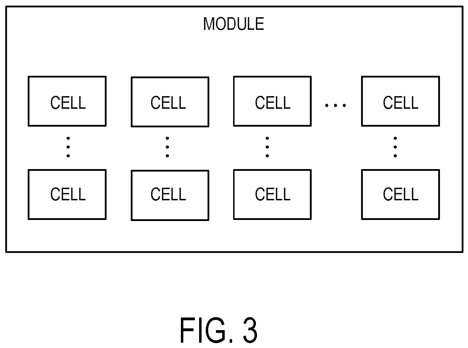

FIG. 3 is a diagram showing a configuration example of a single module. The module includes a plurality of battery cells. The plurality of battery cells are connected in series, in parallel, or in series and in parallel. As an example, two or more battery cells connected in series constitute a basic unit and a plurality of basic units are arranged in parallel.

The rechargeable battery in the present embodiment may be any of a cell, a module, a battery unit, and a battery energy storage system. In the following description, a case where the rechargeable battery is a battery energy storage system will be mainly assumed.

The rechargeable battery evaluation apparatus shown in FIG. 1 includes an input device 102, a SoH estimator 103, a SoH transition case example DB 104, an operation feature calculator 105, an operation feature DB 106, a similar case example selector 108, a SoH transition comparator 109, a SoH transition estimator 112, an output DB 113, and an output device 114.

An operation DB 101 shown in FIG. 1 stores measured data acquired from one or a plurality of storage batteries. A rechargeable battery used for learning will be referred to as a sample rechargeable battery and a rechargeable battery that is an evaluation target (estimation target) will be referred to as a target rechargeable battery. As an example, the operation DB 101 stores measured data from the time of start of use of the rechargeable battery. The measured data may be acquired from the rechargeable battery in operation if the rechargeable battery is being used for a practical application or may be acquired by an experiment. An acquisition unit of measured data may be any of a cell, a module, a battery unit, and a set of a plurality of battery units connected to each other or measured data may be respectively acquired by a plurality of acquisition units. The acquisition unit may differ for each rechargeable battery. For example, measured data of a set of battery units may be acquired in a given battery energy storage system and measured data of a module unit may be acquired in another battery energy storage system. The rechargeable battery that is an evaluation target in the present embodiment may be any of a cell, a module, a battery unit, and a battery energy storage system.

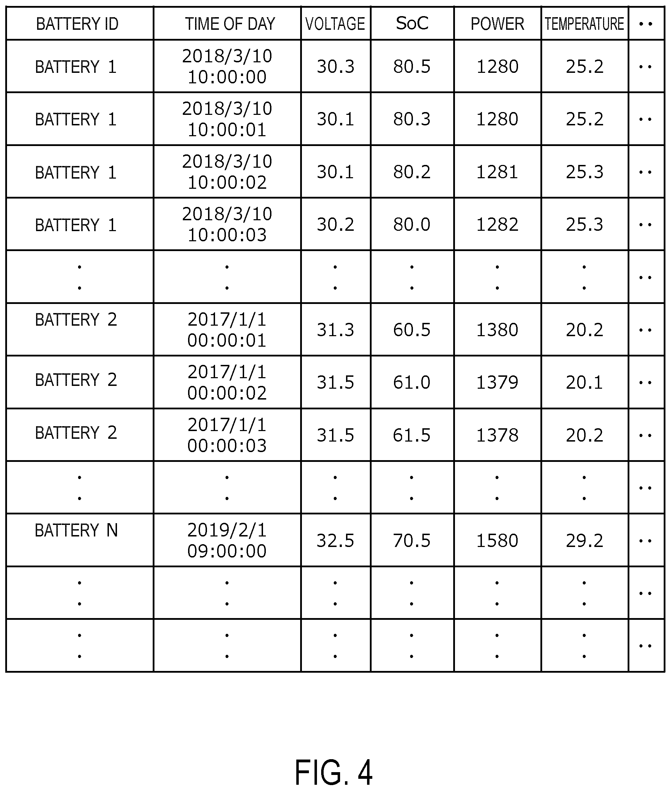

FIG. 4 shows an example of the operation DB 101. The measured data includes measured data (first measured data) related to a rechargeable battery. More specifically, the measured data includes a battery ID, a time of day, a voltage value, a power value, a SoC (state of charge), and a temperature. The measured data may include other information. For example, the measured data may include a flag indicating a state of the rechargeable battery at the time of acquisition of the measured data such as during charge, during discharge, during system operation (hereinafter, during operation), and during system non-operation (hereinafter, during non-operation). Other information such as an application of the rechargeable battery, humidity, weather, or the like may be included in the measured data. In addition, the measured data may include a value indicating a state of the rechargeable battery such as, specifically, a degree of soundness (SoH) of the rechargeable battery. The degree of soundness represents a degree of progress of deterioration of the rechargeable battery.

While measured data is acquired in 1-second intervals in the example shown in FIG. 4, an acquisition interval may be another value such as one minute, five minutes, or one hour. In addition, the acquisition interval need not be a constant time interval and the acquisition interval may differ depending on, for example, a time slot, a use mode of the rechargeable battery, or the like. The voltage value includes a charge voltage or a discharge voltage. A current value may be acquired instead of the power value. In this case, a power value may be calculated from the current value and the voltage value by computation. In addition, a current value may be acquired instead of the SoC value and a SoC may be calculated by integrating currents. The SoC is an indicator of a charge amount of a battery. The SoC may be calculated by dividing a power amount (amount of electric charge) accumulated in the rechargeable battery by a capacity of the rechargeable battery.

The rechargeable battery evaluation apparatus 100 shown in FIG. 1 is equipped with a learning mode in which operation feature case examples and SoH transition case examples are respectively accumulated in an operation feature case example DB 107 and the SoH transition case example DB 104. In addition, the rechargeable battery evaluation apparatus 100 is equipped with an estimation mode in which a SoH (deterioration state) is estimated as a state of the rechargeable battery that is an evaluation target based on the operation feature case example DB 107 and the SoH transition case example DB 104. The estimation of the SoH includes an estimation (in other words, prediction) of a future SoH.

The input device 102 acquires measured data of the rechargeable battery from the operation DB 101 in the learning mode or the estimation mode and provides the operation feature calculator 105 with the acquired measured data. In addition, the input device 102 provides the SoH estimator 103 with the measured data in the learning mode. An operation of acquiring measured data may be performed when receiving instruction data from at least one of the operation feature calculator 105 and the SoH estimator 103. The acquired measured data may be, for example, all of the measured data of the rechargeable battery or measured data in a range defined in advance or an optionally specified range. The range of the acquired measured data can be defined by, for example, a period or an indicator of an amount of use of the rechargeable battery. Examples of an indicator that specifies the amount of use of the rechargeable battery include an equivalent full cycle. The range of the acquired measured data corresponds to the second range of the measured data. In the estimation mode, measured data of a rechargeable battery (target rechargeable battery) that differs from the rechargeable battery used in the learning mode is acquired. A range of the measured data of the target rechargeable battery acquired in the estimation mode is, for example, the first range of the measured data and the second range is assumed to be longer than the first range. Note that there may be cases where measured data of the rechargeable battery that is the same as the measured data used in the learning mode is acquired in the estimation mode.

The operation feature calculator 105 calculates, in the learning mode or the estimation mode, feature data (hereinafter, described as operation feature data) of the rechargeable battery based on the measured data. The operation feature data calculated in the learning mode corresponds to the second feature data. The operation feature data (operation feature data of the target rechargeable battery) calculated in the estimation mode corresponds to the first feature data.

As an example, the operation feature data includes at least one piece of feature information (or feature amount) calculated based on the measured data. As an example of one or more pieces of feature information, the operation feature data acquires a distribution of one or more items in the measured data (for example, at least one of voltage, power, SoC, temperature, and current). The distribution may be a set (series) of values itself or a function that approximates a set of values. Each of one or more pieces of feature information included in the first feature data corresponds to the first feature information and each of one or more pieces of feature information included in the second feature data corresponds to the second feature information.

In addition, the feature information included in the operation feature data may be a quantitative value of each item. Examples of the quantitative value include statistics such as a mean value, a maximum value, a minimum value, or a standard deviation. For example, operation feature data may be a vector including a plurality of pieces of feature information such as (mean voltage, mean power, mean SoC, mean temperature, mean current value).

The operation feature data may be calculated for each operation type. When the measured data does not include an operation type, the operation type of the rechargeable battery may be estimated from a current value. For example, a power supply application may be estimated when a current flows in a charge direction for a certain amount of time or more (for example, when charging a rechargeable battery for an EV) or when a current flows in a discharge direction for a certain amount of time or more (for example, when a rechargeable battery for an EV is being used as a power source). In addition, a power supply application may be estimated when regenerative power is acquired such as during travel of an EV and a current can be considered to be flowing in the discharge direction for a certain amount of time if smoothing is performed (when there is a certain amount of charge due to regenerative power but a current can be considered to be flowing in the discharge direction as a whole). A power adjustment application may be estimated when charge or discharge of less than a certain amount of time is repeated (for example, when the rechargeable battery is being used to adjust supply and demand of a power system). A power supply application and a power adjustment application may be mixed.

In the learning mode, operation feature data (second feature data) calculated by the operation feature calculator 105 is associated with identification information (ID) of the rechargeable battery and stored in the operation feature case example DB 107 as an operation feature case example. For example, an operation feature case example of (battery ID, operation feature data) is stored. Information on a data use range (second range) used to calculate the operation feature data (second feature data) may be included in an operation feature case example. In this case, data of (battery ID, range, operation feature data) is stored in the operation feature case example DB 107. Hereinafter, operation feature data included in an operation feature case example may also be described an operation feature case example.

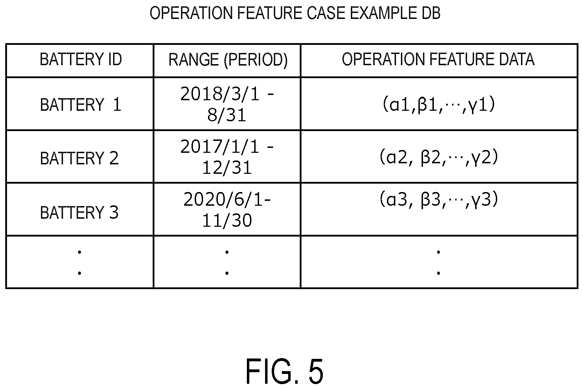

FIG. 5 shows an example of the operation feature case example DB 107. A set including a battery ID, a range (data use range), and operation feature data is stored as a single entry. For example, a battery 1 stores operation feature data (operation feature case examples) calculated based on six months' worth of measured data from March 1, 2018 to August 31, 2018. The six months from March 1, 2018 to August 31, 2018 corresponds to the second range that is the data use range (data measurement range) of the measured data of the battery 1.

On the other hand, in the estimation mode, operation feature data (first feature data) calculated by the operation feature calculator 105 is stored in the operation feature DB 106. Identification information (ID) of the target rechargeable battery may be associated with the operation feature data. In this case, for example, data of (battery ID, operation feature data) is stored. Information on a data use range of measured data used to calculate the operation feature data may be further stored.

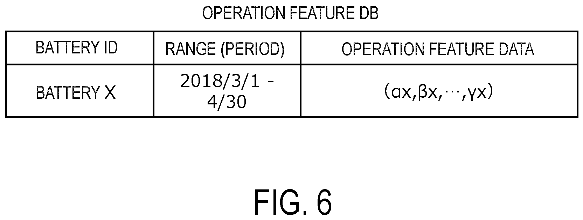

FIG. 6 shows an example of the operation feature DB 106. A set including a battery ID of the target rechargeable battery, a range (data use range), and operation feature data is stored. For example, a battery X stores operation feature data calculated based on two months' worth of measured data from March 1, 2018 to April 30, 2018. The two months from March 1, 2018 to April 30, 2018 corresponds to the first range that is the data use range (data measurement range) of the measured data of the target rechargeable battery.

The SoH estimator 103 (state estimator) estimates, in the learning mode, a SoH that is a state of the rechargeable battery (sample rechargeable battery) based on the measured data. The SoH estimator 103 divides measured data into segments in predetermined division units and estimates the SoH of each segment. The segment may be set in time widths such as one day or one week or segmentation may be performed in accordance with an operation type in addition to a time width. In addition, segmentation may be performed based on an equivalent full cycle (to be described later). The SoH estimator 103 generates a SoH transition case example by associating an ID of the rechargeable battery (sample rechargeable battery) and information (for example, a date or a range) specifying each segment with data (SoH transition data) created by arranging SoH of each segment in a time series. In other words, a SoH transition case example includes a battery ID, a sequence of SoH, and identification specifying each segment (a range, an equivalent full cycle, or the like).

As an example, an estimation target range of a SoH may be the same as a data use range (second range) of the measured data used in estimation of the SoH. The estimation target range of a SoH may at least include a fourth range subsequent to a length of the first range (data use range of the measured data of the target rechargeable battery) described above from a start of the second range. As an example of the fourth range, in the battery 1 shown in FIG. 5, since two months from the start of the range from March 1, 2018 to August 31, 2018 corresponds the length of the first range (refer to FIG. 6), a range from May 1 to August 31 corresponds to the fourth range. A SoH transition case example may be state-related data that is related to a state of the sample rechargeable battery in at least the fourth range among the second range. In the example of the present embodiment, a SoH transition case example corresponds to state-related data that is related to a state of the sample rechargeable battery in the second range.

As a method of estimating a SoH from measured data for each segment, the SoH estimator 103 can use any existing method. For example, based on measured data belonging to a segment, values are plotted on an coordinate system of which an axis of abscissa represents a charge amount (SoC) and an axis of ordinate represents voltage to obtain a QV plot. Range information of voltage in a predetermined charge amount range (for example, a range of SoC 60 to 66%) in the QV plot is calculated. For example, a standard deviation is calculated as voltage range information. Based on training data created by associating the standard deviation and a SoH with each other in advance, the SoH corresponding to the calculated standard deviation is obtained. The training data associating the standard deviation and a SoH with each other may be a table or may be a function using standard deviation as an input variable and the SoH as an output variable. A SoH may be estimated using a method described in Japanese Patent No. 6313502.

When a SoH is associated with measured data stored in the operation DB 101, the SoH may be used. For example, statistics such as a mean value, a maximum value, or a minimum value of the SoH associated with the measured data may be used. As a specific example, when a segment of calculation of a SoH is one week units and a SoH is associated with measured data in one day units, a mean of one week's worth of (seven pieces of) SoH may be calculated as the SoH in the segment. As another example, when a measured value of a SoH is provided from a user or the like as a separate input, the value may be used.

A SoH transition case example (state-related data) generated by the SoH estimator 103 is stored in the SoH transition case example DB 104. A SoH transition case example in the SoH transition case example DB 104 and an operation feature case example (second feature data) in the operation feature case example DB 107 are associated with each other via a battery ID. Alternatively, SoH transition data and an operation feature case example are associated with each other via a set including a battery ID and a data use range. The SoH transition case example DB 104 and the operation feature case example DB 107 correspond to an example of correspondence information which associates a plurality of pieces of second feature data based on measured data related to a plurality of storage batteries (sample storage batteries) and state-related data that is related to a SoH (state) of the plurality of storage batteries with each other.

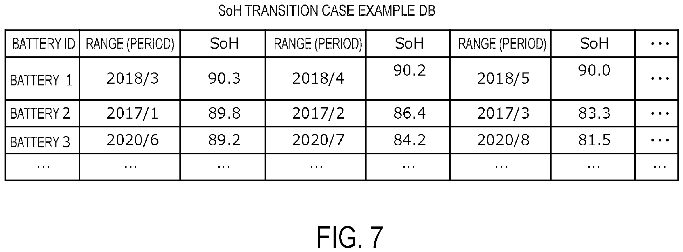

FIG. 7 shows an example of the SoH transition case example DB 104. A plurality of sets including a battery ID, a SoH, and a range are stored as a single entry. In the present example, a segment is a monthly range. As an example, the SoH transition case example DB 104 stores SoH from the time of start of use of the rechargeable battery.

The similar case example selector 108 reads, in the estimation mode, operation feature data (first feature data) calculated by the operation feature calculator 105 or, in other words, operation feature data of the target rechargeable battery from the operation feature DB 106. The similar case example selector 108 selects one or a plurality of operation feature case examples (second feature data) that are similar to the operation feature data (first feature data) of the target rechargeable battery. The selected operation feature case example will be referred to as a similar case example. The similar case example selector 108 acquires the selected similar case example from the operation feature case example DB 107. The similar case example selector 108 acquires a SoH transition case example (state-related data) corresponding to the acquired similar case example (second feature data) from the SoH transition case example DB 104. The similar case example selector 108 corresponds to the first selector that selects at least one operation feature case example from a plurality of operation feature case examples based on a distance between operation feature data (first feature data) of the target rechargeable battery and a plurality of operation feature case examples (second feature data).

A SoH transition case example corresponding to a similar case example is, for example, a SoH transition case example having a same battery ID as the similar case example.

When operation feature data (first feature data) of the target rechargeable battery is separately provided from the outside by a user input or the like, the operation feature data provided as the input may be used instead of the operation feature data calculated by the operation feature calculator 105.

An example of acquiring a similar case example (second feature data) that is similar to operation feature data (first feature data) of the target rechargeable battery will now be shown. As an example, a distance between the operation feature data of the target rechargeable battery and an operation feature case example is calculated. When the operation feature data is a distribution, a distance between distributions is calculated. Examples of a distance between distributions include a Kullback-Leibler distance, a Pearson distance, and a relative Pearson distance. An operation feature case example that satisfies a selection criterion (first selection criterion) such as the distance being minimum, the distance being equal to or smaller than a threshold, or the distance being a certain number from a minimum is selected.

When the operation feature data of the target rechargeable battery includes a plurality of distributions as a plurality of pieces of feature information, a distance is calculated for each distribution and a distance vector that includes the plurality of calculated distances as elements is obtained. An operation feature case example that satisfies a selection criterion such as the distance vector being a minimum, the distance vector being equal to or smaller than a threshold, or the distance vector being a certain number from a minimum is selected.

When the operation feature data of the target rechargeable battery includes one or more quantitative values (feature values) as one or more pieces of feature information, a distance is calculated between vectors including one or more quantitative values (between operation feature data and an operation feature case example). Examples of a distance between vectors include a Euclidean distance, a Manhattan distance, and a Mahalanobis' distance. Alternatively, a distance may be calculated by weighting and adding the distances or by normalizing and adding the distances.

When the operation feature data of the target rechargeable battery includes a mixture of distributions and quantitative values, a distance between distributions is calculated, a distance between vectors of the quantitative values is calculated, and both distances are added. Accordingly, a distance between the operation feature data of the target rechargeable battery and an operation feature case example can be calculated.

The SoH transition estimator 112 (estimator) creates, by machine learning, a model representing a relationship between an operation feature case example and a SoH transition case example based on one or more sets including a similar case example and a SoH transition case example which correspond to each other having been acquired by the similar case example selector 108. More specifically, a regression model that uses operation feature data or feature information as one or more input variables (explanatory variables) and a SoH or a transition of SoH as an output variable (target variable) is generated. Coefficients and constants included in the regression model are decided (learned) by performing optimization or quasi-optimization in accordance with a type of the regression model. While examples of the regression model include linear regression, nonlinear regression, a neural network, a random forest, and SVR, other types may be used as long as a regression model can be constructed. A form of a model (function) is determined in advance and only a coefficient of the explanatory variable and a constant term may be calculated (learned) by optimization or quasi-optimization. The function may be a linear function or an exponential function.

The SoH transition estimator 112 estimates a SoH of the target rechargeable battery or, more specifically, a transition of a SoH using the model and the operation feature data of the target rechargeable battery (operation feature data used to acquire similar case examples). The transition of a SoH includes the SoH at a plurality of times of day. An output of the model is obtained by giving one or more pieces of feature information included in the operation feature data of the target rechargeable battery to one or more explanatory variables of the model. The output of the model represents an estimated value of a SoH or an estimated transition of a SoH.

The output DB 113 stores the estimated transition data of a SoH estimated by the SoH transition estimator 112 in association with information (for example, a battery ID) related to the target rechargeable battery. In addition, the output DB 113 may store information such as operation feature data of the target rechargeable battery calculated by the operation feature calculator 105, a similar case example, and a SoH transition case example that corresponds to a similar case example.

The output device 114 outputs evaluation result information based on the information stored in the output DB 113. For example, the output device 114 outputs estimated transition data of a SoH estimated with respect to the target rechargeable battery. The output device 114 is a display device that displays data or information on a screen. Alternatively, the output device 114 may be a transmitter that transmits information to another device in a wired or wireless manner. The other device to be an target of transmission of information may be a terminal device owned by a user of the present apparatus, a server that remotely monitors the target rechargeable battery, or a device to which the rechargeable battery is mounted.

As an example, when using a neural network as a model, each piece of feature information of operation feature data of the target rechargeable battery is assigned to an input node. SoH in an evaluation range including a third range that differs from the data use range (first range) of operation feature data is output from one or a plurality of output nodes. The third range is, for example, a range subsequent to the first range. The third range is a range equal to or shorter than a length obtained by subtracting a length of the first range from a length of the second range. The plurality of output nodes correspond to SoH of different time points and a set of the SoH corresponds to a transition of SoH. The evaluation range may include both a data use range (first range) of operation feature data and the third range after the data range. A length of the evaluation range may be the same as a data use range of measured data of the sample rechargeable battery used in learning (for example, a longest data use range among data use ranges of a plurality of sample storage batteries).

As the explanatory variable of the model, at least one of an elapsed time, an equivalent full cycle, a total power amount (Wh), and a total current amount (Ah) may be added as feature information to the model besides operation feature data. A reference time point of the elapsed time or the like may be a time of start of use of the rechargeable battery or may be another time point. Among two axes when displaying a graph of SoH transition on a two-dimensional coordinate system formed by the two axes, the feature information may be information corresponding to an axis (for example, an axis of abscissa) that differs from an axis of SoH (for example, an axis of ordinate).

In other words, the model may be a function with an elapsed time (or an equivalent cycle, a total power amount, a total current amount, or the like) as an independent variable and a SoH as a dependent variable. In this case, the function itself is data representing a transition of SoH. An example of the function in this case is shown in equation (1) below.

[Expression 1]

$$f(x) = k * (x^2 + a)^{\frac{1}{2}} + b \quad \dots (1)$$

Equation (1) represents a function which is initially gradual with a gradient of 0 and which gradually approaches y=k*x+b. Reference character x denotes an explanatory variable (independent variable) such as an elapsed time, an equivalent cycle, a total power amount, or a total current amount. Reference characters k, a, and b denote values including an explanatory variable (feature information) to be an input or constants (coefficients) determined in model learning. Reference character f(x) denotes a target variable (dependent variable).

As a specific example, when a similar case example is acquired using feature information other than temperature among the feature information included in operation feature data, a model such as that expressed by equation (1) described above may be generated using only the feature information related to temperature and elapsed time as explanatory variables. An equivalent cycle, a total power amount, a total current amount, or the like may be used instead of the elapsed time. In doing so, reference character k in equation (1) may be calculated according to, for example, an Arrhenius equation representing a relationship between temperature and a chemical reaction. An example of a calculation formula of k is shown in equation (2).

[Expression 2]

$$k = d * exp(-\frac{e}{(t+273.15)}) \quad \dots (2)$$

Note that when a similar case example is acquired using feature information related to temperature among the feature information included in operation feature data, a model such as that expressed by equation (1) described above may be generated in a similar manner using only the feature information related to temperature and an elapsed time as explanatory variables. An equivalent cycle, a total power amount, a total current amount, or the like may be used instead of the elapsed time.

Among a plurality of methods of generating the model described above, a method that minimizes error may be selected. Ensemble estimation such as using a mean value of estimated values of models calculated by the plurality of methods may be performed.

Instead of generating a model with the SoH transition estimator 112, a model may be stored in advance in a storage that is accessible from the SoH transition estimator 112. In this case, the SoH transition estimator 112 may read the model from the storage and estimate a transition of SoH based on the read model and the operation feature data of the target rechargeable battery.

When feature information is a sequence of values, a value obtained by accumulating the values may be used as an explanatory variable. For example, when feature information in the operation feature data is time-series data of temperature for each unit time, an accumulated value of temperatures may be used as an explanatory variable. Alternatively, a mean of temperatures may be calculated at constant time intervals in the time-series data and an accumulation of the calculated mean may be used as an explanatory variable.

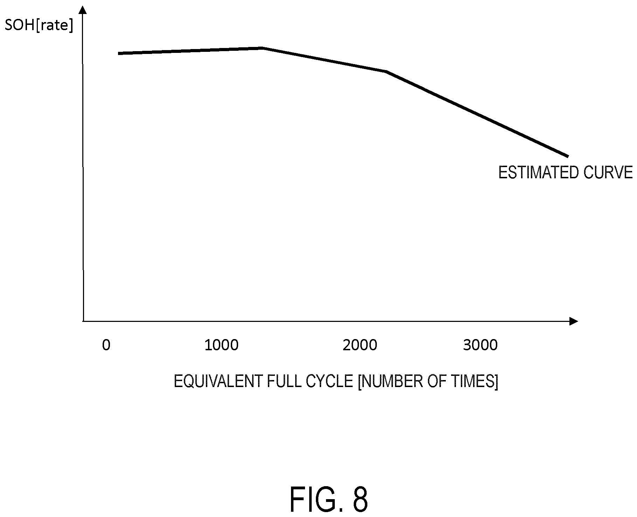

FIG. 8 shows an example of estimated transition data of SoH (SoH estimated transition data or SoH estimated curve) estimated by the SoH transition estimator 112. In the present example, an axis of abscissa represents an equivalent full cycle. An equivalent full cycle is a value obtained by dividing an integrated current amount by a rated capacity value and is an indicator of the number of times a full charge or a complete discharge has been performed. In other words, an equivalent full cycle can be described as representing an amount of use of the rechargeable battery. An axis of abscissa is not limited to an equivalent full cycle and may be a date, a current amount [Ah], or a power amount [Wh]. In the case of a rechargeable battery mounted to a mobile object such as an EV, the axis of abscissa may be a travel distance of the mobile object.

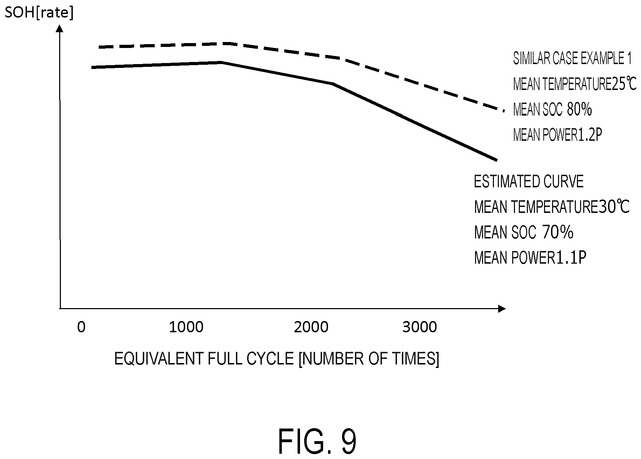

FIG. 9 shows an example of displaying, in addition to SoH estimated transition data (SoH estimated curve) estimated by the SoH transition estimator 112, data of a SoH transition case example corresponding to an operation feature case example (similar case example) acquired by the similar case example selector 108. In this example, among a plurality of SoH transition case examples corresponding to the plurality of acquired similar case examples, a SoH transition case example corresponding to one similar case example of which a distance to the operation feature data of the target rechargeable battery is minimal or equal to or shorter than a threshold is displayed. Two or more similar case examples may be selected and a SoH transition case example corresponding to each of the selected similar case examples may be displayed. In addition, in the example shown in FIG. 9, a similar case example is displayed in association with a SoH transition case example corresponding to the similar case example, and an operation feature data of the target rechargeable battery is displayed in association with the estimated SoH estimated transition data. Three pieces of feature information, namely, a mean temperature, a mean SOC, and mean power are respectively displayed as information based on the similar case example (information based on the second feature data) and information based on the operation feature data of the target rechargeable battery (information based on the first feature data). When there is a large number of pieces of feature information, information based on the similar case example and information based on the operation feature data of the target rechargeable battery may be displayed when a user specifies a graph of a SoH transition case example or a SoH estimated curve (for example, when a pointer is placed over a graph by a mouse operation).

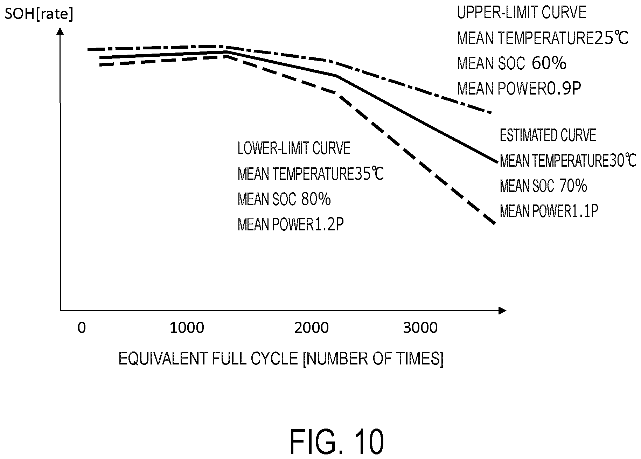

FIG. 10 displays, in addition to SoH estimated transition data (SoH estimated curve) estimated by the SoH transition estimator 112, a SoH transition case example of an upper limit (an upper-limit curve) and a SoH transition case example of a lower limit (a lower-limit curve). The upper-limit curve is, for example, a SoH transition case example in which a progress of deterioration is slowest among SoH transition case examples corresponding to a similar case example. The lower-limit curve is, for example, a SoH transition case example in which a progress of deterioration is fastest among SoH transition case examples corresponding to a similar case example.

For example, let us assume that operation feature data of the target rechargeable battery includes a mean temperature, a mean SOC, and mean power. Deterioration is known to progress faster when the temperature is higher, when SoC is closer to both ends of a use range of SoC, and when used power is larger. For example, a similar case example of which a mean temperature is higher, a mean SOC is closer to one of both ends, and mean power is higher than the mean temperature, the mean SOC, and the mean power indicated by operation feature data of the target rechargeable battery may be specified among similar case examples and a SoH transition case example corresponding to the specified similar case example may be adopted as the lower-limit curve. In a similar manner, a similar case example of which a mean temperature is lower, a mean SOC is farther from one of both ends, and mean power is lower than the mean temperature, the mean SOC, and the mean power indicated by operation feature data of the target rechargeable battery may be specified among similar case examples and a SoH transition case example corresponding to the specified similar case example may be adopted as the upper-limit curve.

When operation feature data of the target rechargeable battery includes a mean value of any item such as temperature, operation feature data A in which the mean value included in the operation feature data is replaced with a maximum value and operation feature data B in which the mean value included in the operation feature data is replaced with a minimum value may be generated. SoH estimated transition data (SoH estimated curve) is acquired using each of the operation feature data A and the operation feature data B (at least using the maximum value or the minimum value). Each of the acquired SoH estimated curves is used as the lower-limit curve or the upper-limit curve. Note that a value higher than an "N sigma mean" and a value lower than the "N sigma mean" may be used instead of the maximum value and the minimum value. The N sigma mean refers to a value obtained by adding N-times a standard deviation (sigma) to the mean value and a value obtained by subtracting N-times the standard deviation (sigma) from the mean value. Reference character N denotes, for example, an integer that is 1, 2, or 3.

When operation feature data corresponding to a SoH estimated curve (in other words, operation feature data of target rechargeable battery) is not included in a similar case example, estimation accuracy of the model may possibly decline. Therefore, the SoH transition estimator 112 may determine whether the operation feature data corresponding to the SoH estimated curve is included in a similar case example and, if not, cause a message (warning) related to estimation accuracy to be displayed on the output device 114. For example, the message includes information indicating that the estimation accuracy may possibly be low. The determination of whether or not operation feature data is included in a similar case example can be confirmed based on whether or not a value of feature information in the operation feature data is included between a minimum value and a maximum value of the feature information in the similar case example. Otherwise, whether or not operation feature data is included may be detected using an outlier detection method such as Hotelling's theory or a One Class SVM (support vector machine).

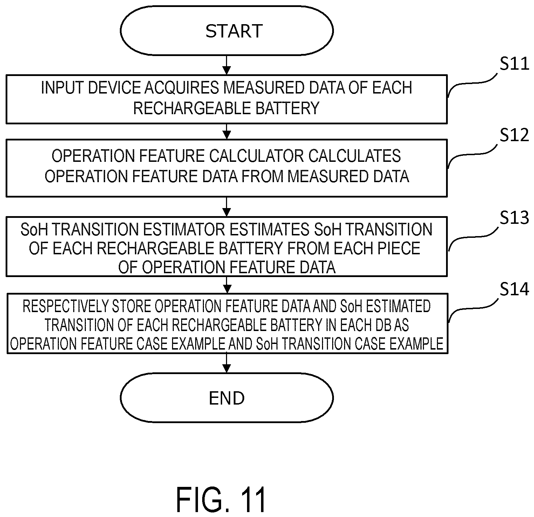

FIG. 11 is a flow chart showing an example of an operation in the learning mode in the rechargeable battery evaluation apparatus 100 according to the present embodiment.

In step S11, the input device 102 acquires measured data of a plurality of storage batteries (sample storage batteries) from the operation DB 101. A data use range of the measured data of the sample storage batteries is, as an example, the second range that is longer than a data use range (first range) of the measured data of the target rechargeable battery. The length of the second range may be the same in all sample storage batteries or may differ among the sample storage batteries. When the length of the second range differs among the sample storage batteries, the sample storage batteries may be sectioned by ranges of a same length from start of use and measured data of the ranges of a same length may be used. Alternatively, all of the measured data of each sample rechargeable battery may be used regardless of the length of the second range.

In step S12, the operation feature calculator 105 calculates operation feature data (second feature data) of each rechargeable battery based on the measured data of each rechargeable battery acquired in step S11.

In step S13, the SoH estimator 103 calculates SoH transition data (state-related data) of each rechargeable battery based on the measured data of each rechargeable battery. A range of the SoH transition data is, as an example, the second range that is the same as the data use range of the measured data of the storage batteries. The range of the SoH transition data may include at least a part of a fourth range subsequent to a length of the first range from the start of the second range among the second range. A configuration in which a SoH is associated with measured data in advance is also possible. In this case, the SoH estimator 103 may acquire SoH transition data based on the SoH.

In step S14, the operation feature calculator 105 stores the operation feature data (second feature data) calculated in step S12 in the operation feature case example DB 107 as an operation feature case example in association with an ID or the like of each rechargeable battery. The SoH estimator 103 stores SoH transition data in the SoH transition case example DB 104 as a SoH transition case example in association with an ID of a rechargeable battery, a data use range, and the like.

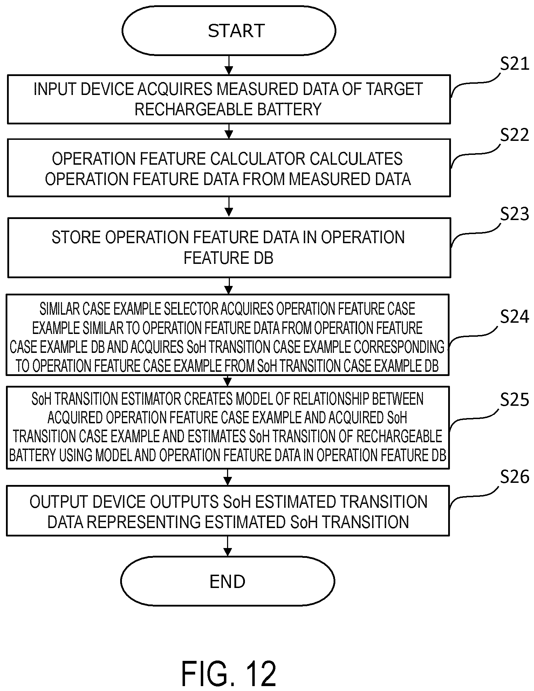

FIG. 12 is a flow chart showing an example of an operation in the estimation mode in the rechargeable battery evaluation apparatus 100 according to the present embodiment.

In step S21, the input device 102 acquires measured data of the target rechargeable battery from the operation DB 101.

In step S22, the operation feature calculator 105 calculates operation feature data (first feature data) of the target rechargeable battery based on the measured data of the target rechargeable battery.

In step S23, the operation feature calculator 105 stores the calculated operation feature data in the operation feature DB 106 in association with an ID or the like of the rechargeable battery.

In step S24, the similar case example selector 108 reads operation feature data of the target rechargeable battery from the operation feature DB 106. The similar case example selector 108 acquires one or more operation feature case examples satisfying a selection criterion with respect to the operation feature data (being similar to the operation feature data) from the operation feature case example DB 107 as similar case examples. The similar case example selector 108 acquires SoH transition case examples corresponding to the similar case examples from the SoH transition case example DB 104 based on the battery ID.

In step S25, the SoH transition estimator 112 learns a relationship between the similar case examples selected in step S24 and the SoH transition case examples corresponding to the similar case examples and generates a model. The SoH transition estimator 112 calculates SoH estimated transition data (SoH estimated curve) of the target rechargeable battery based on the generated model and the operation feature data of the target rechargeable battery read in step S23. A range of the SoH estimated curve is, as an example, an evaluation range that includes the data use range (first range) of the measured data of the target rechargeable battery and the third range subsequent to the first range. The evaluation range includes at least the third range among the third range and the first range.

In step S26, the output device 114 outputs the SoH estimated transition data of the target rechargeable battery (SoH estimated curve).

In the present embodiment, the relationship between the similar case examples selected in step S24 and the SoH transition case examples corresponding to the similar case examples is learned to generate a model and SoH estimated transition data of the target rechargeable battery is generated using the model. As a simpler method, one similar case example may be selected and a SoH transition case example corresponding to the selected similar case example may be adopted as the SoH estimated transition data of the target rechargeable battery.

As described above, according to the present embodiment, a transition of a SoH of a rechargeable battery that is an evaluation target is estimated from operation feature case examples and SoH transition case examples of various storage batteries used in use modes of various operation types of the batteries and from operation feature data of the target rechargeable battery. As a result, estimation accuracy of the transition of a SoH of the target rechargeable battery can be improved.

(First modification)

Contents of operation feature data to be calculated from measured data of a rechargeable battery may be changed according to a type of a use mode (operation type) of the rechargeable battery. For example, use modes of the rechargeable battery can be roughly divided into cases where the rechargeable battery is used for power adjustment such as a power stabilization application of a system and cases where the rechargeable battery is used as a power source as in an EV.

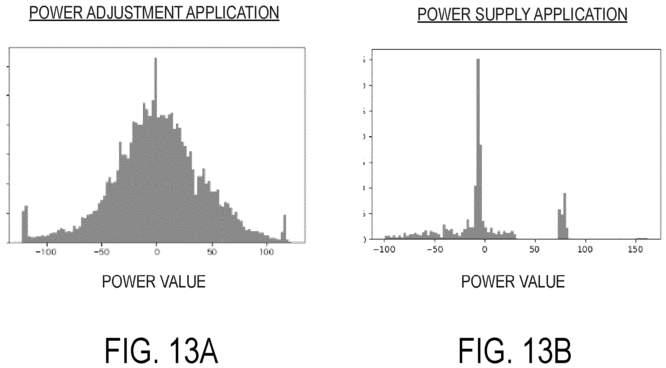

FIG. 13A shows an example of a power distribution in a case of a power adjustment application. In the case of a power adjustment application, charge and discharge are repeated in short time intervals and a mean power value approaches 0. A standard deviation of power values is appropriate as an indicator of strength of power. Therefore, in the case of a rechargeable battery for a power adjustment application, the standard deviation of power values may be used as one of the pieces of feature information to be included in operation feature data.

FIG. 13B shows an example of a power distribution in a case of a power supply application. In the case of a power supply application, the rechargeable battery is charged at once and used so that discharge takes place gradually. Therefore, two peaks including one for charge and one for discharge are formed (in other words, two unimodal distributions are formed). Therefore, as feature information included in operation feature data, feature information of each of the two unimodal distributions (for example, a standard deviation, a peak value, or the like of each distribution) may be used. Alternatively, when calculating operation feature data using only measured data during charge, feature information of a single unimodal distribution may be included in operation feature data as one piece of feature information. In a similar manner, when calculating operation feature data using only measured data during discharge, feature information of a single unimodal distribution may be included in operation feature data as one piece of feature information.

(Second modification)

An operation type of a rechargeable battery may be provided from an external device or a device operated by the user as input. Alternatively, the present rechargeable battery evaluation apparatus may determine an operation type from measured data. Methods of determining an operation type from measured data include a method of determining the operation type from the number of peaks or positions of peaks of a power histogram, a pattern of variation of increase or decrease of a charge amount, or the like. As an example of the pattern of variation, an increase and a decrease are repeated in the case of a power adjustment application but charge or discharge is continuously performed over a certain range or more in the case of a power supply application.

In addition, the user may use an operation device to set an operation type to an operation feature case example stored in the operation feature case example DB 107. The similar case example selector 108 may select a similar case example from among operation feature case examples of a same operation type as the operation type of the target rechargeable battery.

(Third modification)

Operation types may be classified in greater detail. For example, when operation types are power supply applications, the operation types may be classified according to motives of battery energy storage systems such as an EV, an EV bus, and an ocean vessel. When a rechargeable battery is operated while being switched among a plurality of operation types, a ratio of an operation time of each operation type may be calculated and SoH estimated transition data for each operation type may be generated. In addition, by weighting the SoH estimated transition data according to the ratio of each operation type and adding up the pieces of SoH estimated transition data, SoH estimated transition data of the target rechargeable battery may be ultimately generated. In this case, in a similar manner, SoH transition case examples to be stored in the SoH transition case example DB 104 may be generated for each operation type, and by weighting and adding up the generated SoH transition case examples, a SoH transition case example may be generated.

(Fourth modification)

Examples of factors that affect the progress of deterioration of a rechargeable battery include temperature, a charge amount (SoC), and a power value. Therefore, as operation feature data of the target rechargeable battery, operation feature data including only feature information related to at least one of temperature, a charge amount (SoC), a power value, and the like may be used. Alternatively, while ensuring that operation feature data includes feature information related to at least one of temperature, a charge amount (SoC), a power value, and the like, the operation feature data may additionally include other feature information. As a result, estimation accuracy of a SoH can be enhanced.

In addition, with respect to the temperature of a rechargeable battery, a manner of progress (for example, a rate of progress) of deterioration of the rechargeable battery differs between high temperatures and low temperatures. Therefore, feature information indicating how long the rechargeable battery was under a high temperature and under a low temperature may be used. For example, feature information indicating a dwell ratio at 0°C or lower and feature information indicating a dwell ratio at 40°C or higher among a total period of time may be used. Accordingly, estimation accuracy of SoH can be enhanced. At least one of high temperature and low temperature corresponds to the first temperature range of the rechargeable battery and the other corresponds to the second temperature range of the rechargeable battery.

Furthermore, with respect to the charge amount (SoC) of a rechargeable battery, a manner of progress (for example, a rate of progress) of deterioration of the rechargeable battery differs between a complete discharge state and a full charge state. Therefore, feature information indicating how long the rechargeable battery was at a low SoC and at a high SoC may be used. For example, feature information indicating a dwell ratio at SoC 10% or lower, feature information indicating a dwell ratio at SoC 90% or higher, and the like may be used. Accordingly, estimation accuracy of SoH can be enhanced. One of SoC 10% or lower and SoC 90% or higher corresponds to the first charge amount range and the other corresponds to the second charge amount range of the charge amount of the rechargeable battery.

(Fifth modification)

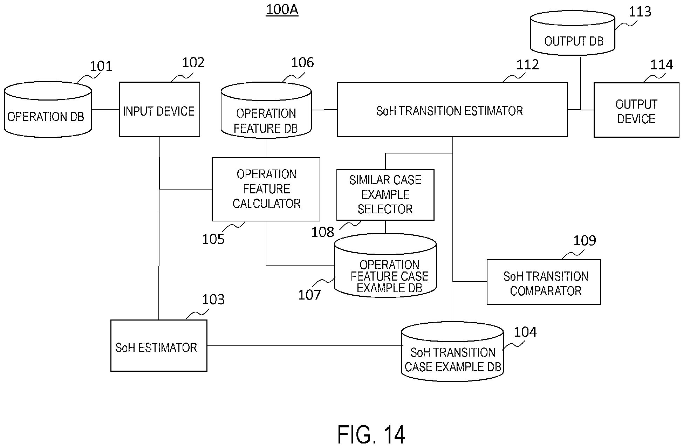

FIG. 14 is a block diagram of an example of a rechargeable battery evaluation apparatus 100A that is an information processing apparatus according to a fifth modification of the present embodiment. Compared to the rechargeable battery evaluation apparatus 100 shown in FIG. 1, a SoH transition comparator 109 (second selector) has been added.

The SoH transition comparator 109 calculates a distance between transition data of SoH up to a present time point of the target rechargeable battery and each SoH transition case example in the SoH transition case example DB 104. The SoH transition data indicates a transition of the SoH in accordance with any of an elapsed time, a power amount (Wh), a current amount (Ah), and the like. The SoH (state) or transition data of the SoH (state) up to the present time point of the target rechargeable battery is calculated by the SoH estimator 103 based on, for example, measured data of the rechargeable battery. Hereinafter, the transition data of the SoH up to the present time point of the target rechargeable battery will be described as target SoH transition data. The present time point corresponds to, for example, a time point at an end of the data use range (first range) of measured data of the target rechargeable battery.

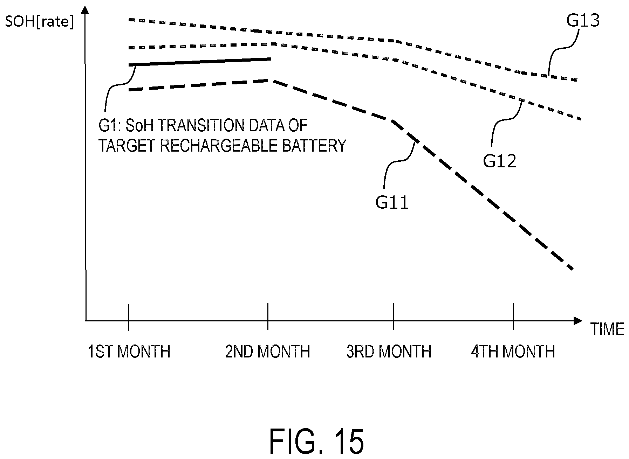

FIG. 15 shows examples of a graph G1 of target SoH transition data and graphs G11 to G13 of each SoH transition case example in the SoH transition case example DB 104. The graph G1 corresponds to SoH transition data of the battery X shown in FIG. 6. The graphs G11 to G13 correspond to SoH transition case examples of the storage batteries 1 to 3 shown in FIG. 5. While three graphs of SoH transition case examples are displayed in the present example for the sake of simplicity, graphs of other SoH transition case examples may be further displayed. An axis of abscissa indicates time and represents an elapsed time from the first month of use. An axis of abscissa may represent an equivalent full cycle in a similar manner to FIGS. 8 to 10.

The target SoH transition data of graph G1 represents a transition of SoH during two months including the first month of use and a next month as an elapsed time H from the start of use of the target rechargeable battery. The graphs G11 to G13 respectively represent six months' worth of SoH, 12 months' worth of SoH, and six months' worth of SoH from the first month of use (however, notation of fifth and subsequent months is omitted). A distance (hereinafter described as a SoH distance) between a portion from the start of use of the rechargeable battery to the elapsed time H (in the present example, two months from the start of use) in the graphs G11 to G13 of the SoH transition case examples and the graph G1 of the SoH transition data is calculated. The calculation of the SoH distance may be performed using a Euclidean distance or a distance scale between pieces of time-series data such as DTW (dynamic time warping). The target SoH transition data and each SoH transition case example may be subjected to smoothing and the SoH distance may be calculated based on the data after smoothing. Alternatively, the target SoH transition data and each SoH transition case example may be respectively fitted to a function with a specific shape and the SoH distance may be calculated between the fitted functions.

The SoH transition estimator 112 selects a SoH transition case example of which the SoH distance satisfies a selection criterion (second selection criterion). The SoH transition estimator 112 corresponds to the second selector which selects at least one of the respective SoH transition case examples based on a distance between the target SoH transition data (state-related data of the target rechargeable battery) and a data portion of a range corresponding to the first range in each SoH transition case example (state-related data). The range corresponding to the first range in each SoH transition case example (state-related data) is, for example, a range corresponding to a length of the first range from the start of use of the rechargeable battery among a range of the SoH transition case example.

Examples of the selection criterion (second selection criterion) include selecting a SoH transition case example with a minimum SoH distance, selecting a SoH transition case example of which the SoH distance is equal to or shorter than a threshold, selecting a certain number of SoH transition case examples from among SoH transition case examples with a minimum SoH distance, and the like. In the selected SoH transition case example, a portion subsequent to a range of which the SoH distance from the target SoH transition data has been calculated is used as estimated transition data of the SoH subsequent to the present time point of the target rechargeable battery. For example, when the SoH transition case example of the graph G12 is selected in FIG. 15, a data portion of the third and subsequent months of the graph G12 becomes estimated data of a SoH transition of the third and subsequent months of the target rechargeable battery. When a plurality of SoH transition case examples are selected, estimated transition data of the SoH of the target rechargeable battery may be acquired based on a mean value of the plurality of SoH transition case examples.

The SoH transition estimator 112 may estimate the SoH transition of the target rechargeable battery using both the SoH distance between the target SoH transition data and each SoH transition case example and a distance between operation feature data of the target rechargeable battery and each operation feature case example in the operation feature case example DB 107. Specifically, SoH transition case examples satisfying the selection criterion (second selection criterion) described above and SoH transition case examples corresponding to the operation feature case example (similar case example) satisfying the selection criterion (first selection criterion) described in the explanation of the first embodiment are selected. All of the selected SoH transition case examples are adopted as a plurality of estimated transition candidates of the SoH of the target rechargeable battery. The plurality of estimated transition candidates may be displayed on the output device 114. Alternatively, a mean or the like of all of the selected SoH transition case examples may be acquired as estimated transition data of the SoH of the target rechargeable battery and the acquired estimated transition data may be displayed on the output device 114.

SoH estimated transition data may be calculated using a model in a similar manner to the first embodiment and the calculated SoH estimated transition data and SoH transition case examples selected based on the SoH distance described above may be displayed on the output device 114 as estimated transition candidates of the SoH of the target rechargeable battery.

The temperature of the rechargeable battery has a large impact on the transition of deterioration. When selecting an operation feature case example (similar case example) satisfying the selection criterion (first selection criterion), an operation feature case example of which a distance between pieces of feature information related to temperature is short may be preferentially selected. Alternatively, in a similar manner to the embodiment described above, an operation feature case example (similar case example) may be acquired based on operation feature data including feature information other than temperature and estimated transition data of a SoH may be calculated using a model including feature information related to temperature as an explanatory variable.

(Hardware configuration)

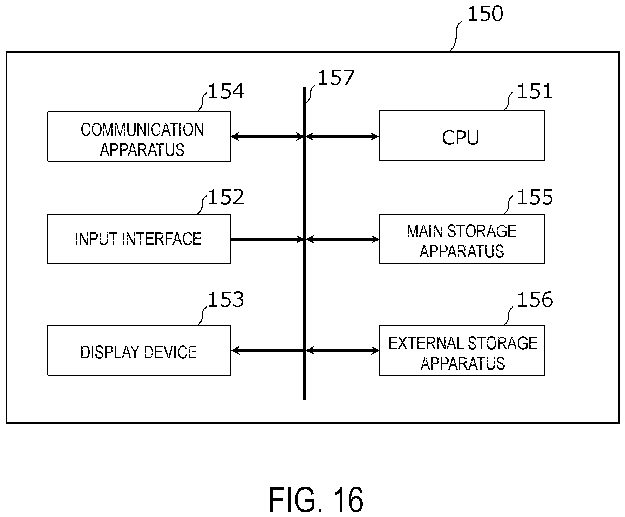

FIG. 16 shows a hardware configuration example of the rechargeable battery evaluation apparatus 100 according to an embodiment of the present invention. The hardware configuration can be used in the rechargeable battery evaluation apparatus 100 according to each embodiment described above. The hardware configuration shown in FIG. 16 is constructed as a computer 150. The computer 150 includes a CPU 151, an input interface 152, a display device 153, a communication apparatus 154, a main storage apparatus 155, and an external storage apparatus 156 which are connected by a bus 157 so as to be mutually communicable.

The input interface 152 acquires measured data of a rechargeable battery via wiring or the like. The input interface 152 may be an operation device used by the user to give instructions to the present apparatus. Examples of the operation device include a keyboard, a mouse, and a touch panel. The communication apparatus 154 includes a wireless or wired communication device and performs wired or wireless communication with an EV 200. Measured data may be acquired via the communication apparatus 154. The input interface 152 and the communication apparatus 154 may be respectively constituted by a separate circuit such as an integrated circuit or may be constituted by a single circuit such as an integrated circuit. The display device 153 is, for example, a liquid crystal display device, an organic EL display device, or a CRT display device. The display device 153 corresponds to the output device 114 shown in FIG. 1.

For example, the external storage apparatus 156 includes a storage medium or the like such as an HDD, an SSD, a memory device, a CD-R, a CD-RW, a DVD-RAM, or a DVD-R. The external storage apparatus 156 stores a program for causing the CPU 151 that is a processor to execute functions of the respective processing devices of the rechargeable battery evaluation apparatus 100. In addition, each DB included in the rechargeable battery evaluation apparatus 100 is also included in the external storage apparatus 156. While only one external storage apparatus 156 is shown, the external storage apparatus 156 may be present in plurality.

Under the control of the CPU 151, the main storage apparatus 155 deploys a control program stored in the external storage apparatus 156 and stores data necessary for executing the program, data created by executing the program, and the like. The main storage apparatus 155 includes any memory or storage such as a volatile memory (a DRAM, an SRAM, or the like) or a non-volatile memory (a NAND flash memory, an MRAM, or the like). Due to the execution by the CPU 151 of the control program deployed in the main storage apparatus 155, functions of the respective processing devices of the rechargeable battery evaluation apparatus 100 are executed. Each DB included in the rechargeable battery evaluation apparatus 100 may also be included in the main storage apparatus 155.

While certain arrangements have been described, these arrangements have been presented by way of example only, and are not intended to limit the scope of the inventions. Indeed, the apparatuses* described herein may be embodied in a variety of other forms; furthermore various omissions, substitutions and changes in the form of the apparatuses described herein may be made.

[Reference Signs List]

| | |
|---|---|
| 100 | storage battery assessment apparatus |
| 100A | storage battery assessment apparatus |
| 102 | input device |
| 103 | SoH estimator (state estimator) |
| 104 | SoH transition case example DB (correspondence information) |
| 105 | operation feature calculator (feature calculator) |
| 106 | operation feature DB |
| 107 | operation feature case example DB (correspondence information) |
| 108 | similar case example selector (first selector) |
| 109 | SoH transition comparator (second selector) |
| 112 | SoH transition estimator (estimator) |
| 113 | output DB |
| 114 | output device |
| 150 | computer |
| 152 | input interface |
| 153 | display device |
| 154 | communication apparatus |
| 155 | main storage apparatus |
| 156 | external storage apparatus |
| 157 | bus |
| 201 | battery energy storage system |

**Claims**

1. An information processing apparatus, comprising:

   a feature calculator configured to calculate first feature data based on measured data of a target rechargeable battery in a first range; and
   an estimator configured to estimate a state of the target rechargeable battery in a third range that differs from the first range based on

the first feature data and
correspondence information which associates at least one piece of second feature data based on measured data of a rechargeable battery in a second range that is longer than the first range with state-related data that is related to a state of the rechargeable battery.

2. The information processing apparatus according to claim 1, wherein
the state-related data is data related to the state of the rechargeable battery in at least a fourth range subsequent to a length of the first range from a start of the second range among the second range.

3. The information processing apparatus according to claim 1 or 2, wherein

the state-related data represents a transition of the state of the rechargeable battery according to time, and
the estimator is configured to estimate a transition of the state of the target rechargeable battery according to time.

4. The information processing apparatus according to any one of claims 1 to 3, further comprising:

a first selector configured to select at least one piece of second feature data from among a plurality of pieces of the second feature data based on a distance between the first feature data and the plurality of pieces of the second feature data, wherein
the estimator is configured to estimate the state of the target rechargeable battery based on at least one piece of state-related data corresponding to the at least one piece of selected second feature data.

5. The information processing apparatus according to claim 4, wherein

the correspondence information corresponds to information related to an operation type of the plurality of storage batteries, and
the first selector is configured to select the at least one piece of second feature data based on an operation type of the target rechargeable battery.

6. The information processing apparatus according to claim 4 or 5, wherein

the at least one piece of state-related data corresponding to the at least one piece of selected second feature data is two or more pieces of state-related data, and
the estimator is configured to estimate, based on the two or more pieces of state-related data, a range in which the state of the target rechargeable battery varies from the estimated state.

7. The information processing apparatus according to any one of claims 1 to 6, wherein

the first feature data includes a plurality of pieces of first feature information that is a plurality of pieces of feature information related to the target rechargeable battery, and
the second feature data includes a plurality of pieces of second feature information that is a plurality of pieces of feature information related to the rechargeable battery.

8. The information processing apparatus according to claim 7, wherein
the estimator is configured to generate, based on the at least one piece of second feature data and the at least one piece of state-related data, a model with at least one piece of feature information as an input variable and a state as an output variable, and to estimate the state of the target rechargeable battery based on the model and the first feature data.

9. The information processing apparatus according to claim 7 or 8, wherein

the at least one piece of selected second feature data is two or more pieces of the second feature data,
the estimator is configured to determine whether a value of the first feature information included in the first feature data is included in a range of a lower-limit value and an upper-limit value of the second feature information included in the two or more pieces of second feature data, the information processing apparatus further comprising an output device configured to output a message related to an estimation accuracy of a state of the target rechargeable battery when the first feature information is not included in the range.

10. The information processing apparatus according to any one of claims 7 to 9, wherein

the plurality of first feature information include feature information related to a temperature of the target rechargeable battery, feature information related to a power value of the target rechargeable battery, and feature information related to a charge amount of the target rechargeable battery, and
the plurality of second feature information include feature information related to a temperature of the rechargeable battery, feature information related to a power value of the rechargeable battery, and feature information related to a charge amount of the rechargeable battery.

11. The information processing apparatus according to any one of claims 7 to 10, wherein

the plurality of first feature information include feature information related to a period of time during which the target rechargeable battery is included in a first temperature range and feature information related to a period of time during which the target rechargeable battery is included in a second temperature range that differs from the first temperature range, and
the plurality of second feature information include feature information related to a period of time during which the rechargeable battery is included in the first temperature range and feature information related to a period of time during which the rechargeable battery is included in the second temperature range.

12. The information processing apparatus according to any one of claims 7 to 11, wherein

the plurality of first feature information include feature information related to a period of time during which the target rechargeable battery is included in a first charge amount range and feature information related to a period of time during which the target rechargeable battery is included in a second charge amount range that differs from the first charge amount range, and
the plurality of second feature information include feature information related to a period of time during which the rechargeable battery is included in the first charge amount range and feature information related to a period of time during which the rechargeable battery is included in the second temperature range.

13. The information processing apparatus according to claim 4, wherein

the at least one piece of first feature information includes feature information related to a temperature of the target rechargeable battery and feature information that differs from the temperature,
the at least one piece of second feature information includes feature information related to a temperature of the rechargeable battery and feature information that differs from the temperature,
the first selector is configured to select the second feature data based on the feature information that differs from the temperature among the at least one piece of first feature information, and
the estimator is configured to estimate a state of the target rechargeable battery based on the feature information related to the temperature among the first feature information included in the first feature data.

14. The information processing apparatus according to any one of claims 1 to 13, comprising:

a state estimator configured to estimate a state of the target rechargeable battery in the first range based on the measured data of the target rechargeable battery in the first range and acquire state-related data representing the state of the target rechargeable battery; and
a second selector configured to select, based on a distance between the state-related data of the target rechargeable battery and a data portion of a range corresponding to the first range of the state-related data included in the correspondence information, at least one piece of state-related data among the state-related data included in the correspondence information, wherein
the estimator is configured to estimate the state of the target rechargeable battery in the third range based on the at least one piece of state-related data selected by the second selector.

15. The information processing apparatus according to claim 3, comprising
an output device configured to display estimated transition data representing a transition of a SoH of the target rechargeable battery as estimated by the estimator.

16. The information processing apparatus according to claim 15, wherein
the output device is configured to display information based on the first feature data together with the estimated transition data.

17. The information processing apparatus according to claim 4, wherein

the state is a SoH,
the state-related data represents a transition of a SoH of the rechargeable battery,
the estimator is configured to estimate a transition of a SoH of the target rechargeable battery,
the estimator is configured to select first state-related data representing a slowest progress of deterioration of the rechargeable battery and second state-related data representing a fastest progress of deterioration of the rechargeable battery among the at least one piece of state-related data corresponding to the at least one piece of selected second feature data, the information processing apparatus comprising:
an output device configured to display estimated transition data representing a transition of a SoH of the target rechargeable battery as estimated by the estimator, the first state-related data, and the second state-related data.

18. The information processing apparatus according to claim 17, wherein
the output device is configured to:

display information based on the first feature data together with the estimated transition data,
display information based on the second feature data corresponding to the first state-related data together with the first state-related data, and
display information based on the second feature data corresponding to the second state-related data together with the second state-related data.

19. The information processing apparatus according to any one of claims 1 to 18, wherein
the third range is a range equal to or shorter than a length obtained by subtracting a length of the first range from a length of the second range.

20. The information processing apparatus according to any one of claims 1 to 19, wherein

the first range is a period during which measured data of the target rechargeable battery is acquired,
the second range is a period during which measured data of the rechargeable battery is acquired, and
the third range is a period during which a state of the target rechargeable battery is estimated.

21. The information processing apparatus according to any one of claims 1 to 19, wherein

the first range is a range of values of an indicator of a use amount of the target rechargeable battery in which measured data of the target rechargeable battery is acquired,
the second range is a range of values of an indicator of a use amount of the rechargeable battery in which measured data of the rechargeable battery is acquired, and
the third range is a range of values of an indicator of a use amount of the rechargeable battery in which a state of the target rechargeable battery is estimated.

22. The information processing apparatus according to claim 21, wherein

the indicator of a use amount of the target rechargeable battery is an equivalent full cycle of the target rechargeable battery, and
the indicator of a use amount of the rechargeable battery is an equivalent full cycle of the rechargeable battery.

23. An information processing method, comprising:

calculating first feature data based on measured data of a target rechargeable battery in a first range; and
estimating a state of the target rechargeable battery in a third range that differs from the first range based on the first feature data and correspondence information which associates at least one piece of second feature data based on measured data of a rechargeable battery in a second range that is longer than the first range and state-related data that is related to a state of the rechargeable battery.

24. A computer program which causes a computer to perform processes, comprising:

calculating first feature data based on measured data of a target rechargeable battery in a first range; and
estimating a state of the target rechargeable battery in a third range that differs from the first range based on

the first feature data and
correspondence information which associates at least one piece of second feature data based on measured data of a rechargeable battery in a second range that is longer than the first range with state-related data that is related to a state of the rechargeable battery.

25. An information processing system, comprising:

a target rechargeable battery; and
a feature calculator configured to calculate first feature data based on measured data of the target rechargeable battery in a first range; and
an estimator configured to estimate a state of the target rechargeable battery in a third range that differs from the first range based on

the first feature data and
correspondence information which associates at least one piece of second feature data based on measured data of a rechargeable battery in a second range that is longer than the first range with state-related data that is related to a state of the rechargeable battery.

100

FIG. 1

BATTERY ENERGY STORAGE SYSTEM

| BATTERY UNIT 1 | BATTERY UNIT 2 | | BATTERY UNIT N |
|---|---|---|---|
| MODULE 1-1 | MODULE 2-1 | | MODULE N-1 |
| MODULE 1-2 | MODULE 2-2 | ... | MODULE N-2 |
| ⋮ | ⋮ | | ⋮ |
| MODULE 1-M | MODULE 2-M | | MODULE N-M |

FIG. 2

FIG. 3

| BATTERY ID | TIME OF DAY | VOLTAGE | SoC | POWER | TEMPERATURE | ·· |
|---|---|---|---|---|---|---|
| BATTERY 1 | 2018/3/10 10:00:00 | 30.3 | 80.5 | 1280 | 25.2 | ·· |
| BATTERY 1 | 2018/3/10 10:00:01 | 30.1 | 80.3 | 1280 | 25.2 | ·· |
| BATTERY 1 | 2018/3/10 10:00:02 | 30.1 | 80.2 | 1281 | 25.3 | ·· |
| BATTERY 1 | 2018/3/10 10:00:03 | 30.2 | 80.0 | 1282 | 25.3 | ·· |
| · · | · · | · · | · · | · · | · · | ·· |
| BATTERY 2 | 2017/1/1 00:00:01 | 31.3 | 60.5 | 1380 | 20.2 | ·· |
| BATTERY 2 | 2017/1/1 00:00:02 | 31.5 | 61.0 | 1379 | 20.1 | ·· |
| BATTERY 2 | 2017/1/1 00:00:03 | 31.5 | 61.5 | 1378 | 20.2 | ·· |
| · · | · · | · · | · · | · · | · · | ·· |
| BATTERY N | 2019/2/1 09:00:00 | 32.5 | 70.5 | 1580 | 29.2 | ·· |
| · · | · · | · · | · · | · · | · · | ·· |
| · · | · · | · · | · · | · · | · · | ·· |

# FIG. 4

OPERATION FEATURE CASE EXAMPLE DB

| BATTERY ID | RANGE (PERIOD) | OPERATION FEATURE DATA |
|---|---|---|
| BATTERY 1 | 2018/3/1 - 8/31 | $(α1, β1, \cdots, γ1)$ |
| BATTERY 2 | 2017/1/1 - 12/31 | $(α2, β2, \cdots, γ2)$ |
| BATTERY 3 | 2020/6/1- 11/30 | $(α3, β3, \cdots, γ3)$ |
| . . | . . | . . |

# FIG. 5

OPERATION FEATURE DB

| BATTERY ID | RANGE (PERIOD) | OPERATION FEATURE DATA |
|------------|----------------|------------------------|
| BATTERY X | 2018/3/1 - 4/30 | $(\alpha x, \beta x, \cdots, \gamma x)$ |

# FIG. 6

SoH TRANSITION CASE EXAMPLE DB

| BATTERY ID | RANGE (PERIOD) | SoH | RANGE (PERIOD) | SoH | RANGE (PERIOD) | SoH | · · · |
|---|---|---|---|---|---|---|---|
| BATTERY 1 | 2018/3 | 90.3 | 2018/4 | 90.2 | 2018/5 | 90.0 | · · · |
| BATTERY 2 | 2017/1 | 89.8 | 2017/2 | 86.4 | 2017/3 | 83.3 | · · · |
| BATTERY 3 | 2020/6 | 89.2 | 2020/7 | 84.2 | 2020/8 | 81.5 | · · · |
| … | … | … | … | … | … | … | … |

# FIG. 7

FIG. 8

SOH[rate]

SIMILAR CASE EXAMPLE 1
MEAN TEMPERATURE 25℃
MEAN SOC 80%
MEAN POWER 1.2P

ESTIMATED CURVE
MEAN TEMPERATURE 30℃
MEAN SOC 70%
MEAN POWER 1.1P

0          1000          2000          3000

EQUIVALENT FULL CYCLE [NUMBER OF TIMES]

FIG. 9

SOH[rate]

UPPER-LIMIT CURVE
MEAN TEMPERATURE25℃
MEAN SOC 60%
MEAN POWER0.9P

ESTIMATED CURVE
MEAN TEMPERATURE30℃
MEAN SOC 70%
MEAN POWER1.1P

LOWER-LIMIT CURVE
MEAN TEMPERATURE35℃
MEAN SOC 80%
MEAN POWER1.2P

0          1000          2000          3000

EQUIVALENT FULL CYCLE [NUMBER OF TIMES]

FIG. 10

```
                    ┌─────────────────┐
                    │      START      │
                    └────────┬────────┘
                             │
┌────────────────────────────────────────────────────┐      S11
│  INPUT DEVICE ACQUIRES MEASURED DATA OF EACH         │
│             RECHARGEABLE BATTERY                     │
└────────────────────────────┬───────────────────────┘
                             │
┌────────────────────────────────────────────────────┐      S12
│     OPERATION FEATURE CALCULATOR CALCULATES          │
│   OPERATION FEATURE DATA FROM MEASURED DATA          │
└────────────────────────────┬───────────────────────┘
                             │
┌────────────────────────────────────────────────────┐      S13
│  SoH TRANSITION ESTIMATOR ESTIMATES SoH TRANSITION   │
│  OF EACH RECHARGEABLE BATTERY FROM EACH PIECE        │
│           OF OPERATION FEATURE DATA                  │
└────────────────────────────┬───────────────────────┘
                             │
┌────────────────────────────────────────────────────┐      S14
│ RESPECTIVELY STORE OPERATION FEATURE DATA AND SoH ESTIMATED │
│ TRANSITION OF EACH RECHARGEABLE BATTERY IN EACH DB AS       │
│ OPERATION FEATURE CASE EXAMPLE AND SoH TRANSITION CASE EXAMPLE │
└────────────────────────────┬───────────────────────┘
                             │
                    ┌─────────────────┐
                    │       END       │
                    └─────────────────┘
```

# FIG. 11

START

INPUT DEVICE ACQUIRES MEASURED DATA OF TARGET RECHARGEABLE BATTERY — S21

OPERATION FEATURE CALCULATOR CALCULATES OPERATION FEATURE DATA FROM MEASURED DATA — S22

STORE OPERATION FEATURE DATA IN OPERATION FEATURE DB — S23

SIMILAR CASE EXAMPLE SELECTOR ACQUIRES OPERATION FEATURE CASE EXAMPLE SIMILAR TO OPERATION FEATURE DATA FROM OPERATION FEATURE CASE EXAMPLE DB AND ACQUIRES SoH TRANSITION CASE EXAMPLE CORRESPONDING TO OPERATION FEATURE CASE EXAMPLE FROM SoH TRANSITION CASE EXAMPLE DB — S24

SoH TRANSITION ESTIMATOR CREATES MODEL OF RELATIONSHIP BETWEEN ACQUIRED OPERATION FEATURE CASE EXAMPLE AND ACQUIRED SoH TRANSITION CASE EXAMPLE AND ESTIMATES SoH TRANSITION OF RECHARGEABLE BATTERY USING MODEL AND OPERATION FEATURE DATA IN OPERATION FEATURE DB — S25

OUTPUT DEVICE OUTPUTS SoH ESTIMATED TRANSITION DATA REPRESENTING ESTIMATED SoH TRANSITION — S26

END

FIG. 12

POWER ADJUSTMENT APPLICATION

POWER VALUE

# FIG. 13A

POWER SUPPLY APPLICATION

POWER VALUE

# FIG. 13B

FIG. 14

FIG. 15

150

154

COMMUNICATION
APPARATUS

157

151

CPU

152

INPUT INTERFACE

155

MAIN STORAGE
APPARATUS

153

DISPLAY DEVICE

156

EXTERNAL STORAGE
APPARATUS

## FIG. 16

## INTERNATIONAL SEARCH REPORT

International application No.

**PCT/JP2022/013058**

| A. | CLASSIFICATION OF SUBJECT MATTER |
|---|---|

***H02J 7/00***(2006.01)i; ***G01R 31/367***(2019.01)i; ***G01R 31/392***(2019.01)i; ***H01M 10/48***(2006.01)i
FI:  G01R31/392; H02J7/00 Y; H01M10/48 P; G01R31/367

According to International Patent Classification (IPC) or to both national classification and IPC

| B. | FIELDS SEARCHED |
|---|---|

Minimum documentation searched (classification system followed by classification symbols)

H02J7/00; G01R31/367; G01R31/392; H01M10/48

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2017-91853 A (DENSO CORP) 25 May 2017 (2017-05-25) | 1, 7-8, 20, 23-25 |
|   | paragraphs [0033]-[0051], [0062]-[0063], [0073], fig. 2-3 | |
| Y | | 3, 15-16 |
| A | | 2, 4-6, 9-14, 17-19, 21 |
| Y | JP 2021-185354 A (ENVISION AESC JAPAN LTD.) 09 December 2021 (2021-12-09) | 3, 15-16 |
|   | paragraphs [0011], [0042]-[0043], fig. 2-3 | |
| A | WO 2020/044713 A1 (HONDA MOTOR CO LTD) 05 March 2020 (2020-03-05) | 1-25 |
|   | entire text, all drawings | |
| A | WO 2015/072528 A1 (NEC CORP) 21 May 2015 (2015-05-21) | 1-25 |
|   | entire text, all drawings | |
| A | JP 2019-168453 A (GS YUASA CORP) 03 October 2019 (2019-10-03) | 1-25 |
|   | entire text, all drawings | |
| A | US 2016/0161567 A1 (SAMSUNG ELECTRONICS CO., LTD.) 09 June 2016 (2016-06-09) | 1-25 |
|   | entire text, all drawings | |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **19 May 2022** | **07 June 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

International application No.

**PCT/JP2022/013058**

| C. | DOCUMENTS CONSIDERED TO BE RELEVANT | |
|---|---|---|
| Category* | Citation of document, with indication, where appropriate, of the relevant passages | Relevant to claim No. |
| A | CN 113224806 A (TOYOTA MOTOR CORPORATION) 06 August 2021 (2021-08-06) entire text, all drawings | 1-25 |

Form PCT/ISA/210 (second sheet) (January 2015)

**INTERNATIONAL SEARCH REPORT**
Information on patent family members

International application No.

**PCT/JP2022/013058**

| Patent document cited in search report | | | Publication date (day/month/year) | Patent family member(s) | | | Publication date (day/month/year) |
|---|---|---|---|---|---|---|---|
| JP | 2017-91853 | A | 25 May 2017 | (Family: none) | | | |
| JP | 2021-185354 | A | 09 December 2021 | (Family: none) | | | |
| WO | 2020/044713 | A1 | 05 March 2020 | US | 2021/0291698 | A1 | |
| | | | | entire text, all drawings | | | |
| | | | | CN | 112534625 | A | |
| WO | 2015/072528 | A1 | 21 May 2015 | US | 2016/0356856 | A1 | |
| | | | | entire text, all drawings | | | |
| JP | 2019-168453 | A | 03 October 2019 | US | 2021/0033680 | A1 | |
| | | | | entire text, all drawings | | | |
| | | | | WO | 2019/181729 | A1 | |
| | | | | EP | 3770620 | A1 | |
| | | | | CN | 111868540 | A | |
| US | 2016/0161567 | A1 | 09 June 2016 | KR | 10-2016-0067510 | A | |
| | | | | entire text, all drawings | | | |
| CN | 113224806 | A | 06 August 2021 | (Family: none) | | | |

Form PCT/ISA/210 (patent family annex) (January 2015)

**REFERENCES CITED IN THE DESCRIPTION**

**Patent documents cited in the description**

- US 2020044713 A
- JP 6313502 B